(19) Europäisches Patentamt
European Patent Office
Office européen des brevets

(11) **EP 2 951 596 B1**

(12) **EUROPÄISCHE PATENTSCHRIFT**

(45) Veröffentlichungstag und Bekanntmachung des Hinweises auf die Patenterteilung:
**12.06.2024 Patentblatt 2024/24**

(21) Anmeldenummer: **13802406.2**

(22) Anmeldetag: **11.12.2013**

(51) Internationale Patentklassifikation (IPC):
***G01R 19/165*** (2006.01)

(52) Gemeinsame Patentklassifikation (CPC):
**B60R 21/0173;** G01R 19/16538

(86) Internationale Anmeldenummer:
**PCT/EP2013/076231**

(87) Internationale Veröffentlichungsnummer:
**WO 2014/117896 (07.08.2014 Gazette 2014/32)**

(54) **ENERGIEVERSORGUNGSEINHEIT UND VERFAHREN ZUM BETRIEB EINER ENERGIEVERSORGUNGSEINHEIT ZUR AUTARKEN VERSORGUNG EINES VERBRAUCHERS.**

ENERGY SUPPLY UNIT AND METHOD FOR OPERATING AN ENERGY SUPPLY UNIT FOR AUTONOMOUSLY SUPPLYING A LOAD

MODULE D'ALIMENTATION EN ÉNERGIE ET PROCÉDÉ POUR FAIRE FONCTIONNER UN MODULE D'ALIMENTATION EN ÉNERGIE AFIN D'ALIMENTER UNE CHARGE DE MANIÈRE AUTONOME

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.01.2013 DE 102013201641**

(43) Veröffentlichungstag der Anmeldung:
**09.12.2015 Patentblatt 2015/50**

(73) Patentinhaber: **Robert Bosch GmbH
70442 Stuttgart (DE)**

(72) Erfinder:
• **SIEVERS, Falko
72762 Reutlingen (DE)**
• **SCHUMACHER, Hartmut
71691 Freiberg (DE)**
• **LIST, Carsten
74399 Walheim (DE)**

(56) Entgegenhaltungen:
JP-A- 2007 299 156    US-A- 5 057 697
US-A- 5 142 215    US-A1- 2003 220 026
US-A1- 2007 120 694    US-A1- 2007 139 018

**Beschreibung**

Stand der Technik

Die vorliegende Erfindung bezieht sich auf eine Energieversorgungseinheit zur autarken Versorgung eines Verbrauchers, ein Verfahren zum Betrieb einer Energieversorgungseinheit zur autarken Versorgung eines Verbrauchers sowie auf ein entsprechendes Computerprogrammprodukt.

Spannungsregler werden in sicherheitsrelevanten Systemen bezüglich ihrer Ausgangsspannung überwacht. Nimmt die Eingangsspannung eines solchen Spannungsreglers langsam ab, wie es in gepufferten Energiereserve basierten Systemen (Airbag, etc.) möglich ist, so wird beim Unterschreiten einer minimalen Regler-Eingangsspannung die Ausgangsspannung reduziert. Erreicht die Ausgangsspannung eine untere Überwachungsgrenze, wird ein RESET-Signal (zur Erkennung einer Unterspannung am Regler - Ausgang) ausgelöst, welches als Überwachungssignal zur Steuerung von an den Regler angeschlossenen Verbrauchern verwendet werden kann. Dieser RESET (d. h. das Überwachungssignal RESET) setzt alle digitalen Zustände auf den Startzustand zurück, hält getaktete Programmabarbeitungen an und ebenso digitale State-Maschinen. Ebenso führt dies zu einer synchronen Lastreduzierung des Reglers (Reglerausgangsstrom wird synchron reduziert). Da Spannungsregler einen endlichen Innenwiderstand beim Verlassen des Spannungsregelbereichs nach unten besitzen, führt in diesem Bereich eine Reglerausgangsstromreduktion zu einer Erhöhung der Reglerausgangsspannung durch abnehmenden Regler-Drop. Dies hat zur Folge, dass die RESET-Unterspannungsgrenze erneut überschritten wird, wobei insbesondere bei starker Regler-Eingangspufferung (z. B. bei großer Energiereserve) mehrmalige RESET-Pulse erzeugt werden.

Aus der US 5,142,215 ist eine Energieversorgungseinheit bekannt, umfassend eine Vorrichtung zum Empfangen einer Mehrzahl von Wechselstrompulsen und zum kontrollierten Umwandeln der Pulse in einen Gleichstrom; eine Reservebatterie; einen Umschaltregelschaltkreis, der die Batterie mit dem Gleichstrom verbindet, wobei der Schaltkreis einen ersten FET und einen zweiten FET derart zwischen der Batterie und dem Gleichstromausgang in Reihe geschaltet aufweist, dass die internen Drain-Source-Dioden der FET entgegen der Stromflussrichtung angeordnet sind; und einen Fehlerverstärker zum Überwachen des Gleichstromausgangs und zum Bereitstellen eines Fehlersignals an die Vorrichtung zum Empfangen und Umwandeln und an den Umschaltregelschaltkreis, wobei der erste FET und der zweite FET zum Schützen der Batterie vor einer Überladung durch den Gleichstrom über ihre Dioden derart angeordnet sind, dass ihre Drain-Source-Dioden entgegen der Stromflussrichtung angeordnet sind.

Offenbarung der Erfindung

Vor diesem Hintergrund wird vorliegend eine Energieversorgungseinheit zur autarken Versorgung eines Verbrauchers, eine Personensicherheitsvorrichtung, ein Verfahren zum Betrieb einer Energieversorgungseinheit zur autarken Versorgung eines Verbrauchers sowie auf ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Der hier vorgestellte Ansatz schafft insbesondere eine Energieversorgungseinheit zur autarken Versorgung eines Verbrauchers gemäß Anspruch 1, wobei die Energieversorgungseinheit folgende Merkmale aufweist:

- einen Energiespeicher, der zum Liefern von elektrischer Energie an einen Verbraucher ausgebildet ist, wenn der elektrische Verbraucher von einem Energieversorgungsnetz entkoppelt ist;
- eine Energieversorgungsreglereinheit mit einem mit dem Energiespeicher gekoppelten Eingang zur Aufnahme von elektrischer Energie und einem Ausgang zur Abgabe von elektrischer Energie an den Verbraucher; und
- eine Überwachungseinheit zur Ausgabe eines Überwachungssignals, wobei die Überwachungseinheit ausgebildet, um das Überwachungssignal auf einen Aktivzustand zu setzen, wenn eine zwischen dem Ausgang und einem Referenzpotenzial anliegende Ausgangsspanung geringer als ein vordefinierter Aktivierungsschwellwert der Regelspannung ist, oder wenn eine zwischen dem Ausgang und einem Referenzpotenzial anliegende Ausgangsspanung größer als ein vordefinierter Aktivierungsschwellwert der Regelspannung ist,

wobei die Überwachungseinheit ferner ausgebildet ist, um das Überwachungssignal dann auf einen Inaktivzustand zu setzen, falls die Ausgangsspannung keine Aktivierungsschwelle verletzt und/oder eine zwischen dem Eingang und dem Referenzpotenzial anliegende Eingangspannung der Energieversorgungsreglereinheit wieder über einen Rücksetzschwellwert gestiegen ist oder liegt.

Günstig ist es ferner, wenn auch zeitliche Anforderungen an das RESET-Signal umgesetzt werden. Treten die Bedingungen für einen Übergang vom RESET-"aktiv"-Zustand in einen RESET-"inaktiv"-Zustand ein, so wird dieser im RESET-Signal erst nach einer Verzögerungszeit wirksam. Auch beim umgekehrten Übergang kann eine "kurze" Filterzeit Sinn machen.

Auch schafft der hier vorgestellte Ansatz ein Verfahren zum Betrieb einer Energieversorgungseinheit in einer hier vorgestellten Variante zur autarken Versorgung eines Verbrauchers, wobei das Verfahren die folgenden Schritte aufweist:

- Setzen des Überwachungssignals auf einen Aktivzustand, wenn eine zwischen dem Ausgang und einem Referenzpotenzial anliegende Ausgangspanung geringer als ein vordefinierter Aktivierungsschwellwert ist; und
- Bringen des Überwachungssignals in einen Inaktivzustand, wenn eine zwischen dem Eingang und dem Referenzpotenzial anliegende Eingangspannung wieder über einen Rücksetzschwellwert gestiegen ist.

Ferner schafft der hier vorgestellte Ansatz gemäß einer besonders günstigen Ausführungsform ein Verfahren zum Betrieb einer Energieversorgungseinheit in einer hier vorgestellten Variante zur autarken Versorgung eines Verbrauchers, wobei das Verfahren die folgenden Schritte aufweist:

- Setzen des Überwachungssignals auf einen Aktivzustand, wenn eine zwischen dem Ausgang und einem Referenzpotenzial anliegende Ausgangspanung geringer als ein vordefinierter Aktivierungsschwellwert ist oder wenn eine zwischen dem Ausgang und einem Referenzpotenzial anliegende Ausgangspanung größer als ein vordefinierter Aktivierungsschwellwert ist; wobei ferner ein Starten eines (kurzen) Verzögerungszeitnehmers erfolgt, damit der "aktiv"-Zustand im Überwachungssignal (RESET-Signal) erst nach einer definierten Filterzeit wirksam wird;
- Bringen des Überwachungssignals dann in einen Inaktivzustand, falls die Ausgangsspannung keine Aktivierungsschwelle verletzt und/oder eine zwischen dem Eingang und dem Referenzpotenzial anliegende Eingangspannung der Energieversorgungsreglereinheit wieder über einen Rücksetzschwellwert gestiegen ist oder liegt; und
- Starten eines weiteren Verzögerungszeitnehmers damit der inaktiv Zustand im Überwachungssignal (RESET-Signal) erst nach einer definierten mindest RESET-Aktiv Dauer wirksam wird.

Weiterhin wird ein Steuergerät vorgestellt, das ausgebildet ist, um die Schritte einer Variante eines hier vorgestellten Verfahrens in entsprechenden Einrichtungen durchzuführen bzw. umzusetzen. Auch durch diese Ausführungsvariante der Erfindung in Form eines Steuergeräts kann die der Erfindung zugrunde liegende Aufgabe schnell und effizient gelöst werden.

Somit wird durch den hier vorgestellten Ansatz ein Steuergerät zum Betrieb einer Energieversorgungseinheit in einer hier vorgestellten Variante zur autarken Versorgung eines Verbrauchers vorgestellt, wobei das Steuergerät die folgenden Merkmale aufweist:

- eine Einrichtung zum Setzen des Überwachungssignals auf einen Aktivzustand, wenn eine zwischen dem Ausgang und einem Referenzpotenzial anliegende Ausgangspanung geringer als ein vordefinierter Aktivierungsschwellwert ist; und
- eine Einrichtung zum Bringen des Überwachungssignals in einen Inaktivzustand, wenn eine zwischen dem Eingang und dem Referenzpotenzial anliegende Eingangspannung wieder über einen Rücksetzschwellwert gestiegen ist.

Insbesondere wird gemäß einer besonderen Ausführungsform der vorliegenden Erfindung ein Steuergerät zum Betrieb einer Energieversorgungseinheit in einer hier vorgestellten Variante zur autarken Versorgung eines Verbrauchers vorgestellt, wobei das Steuergerät die folgenden Merkmale aufweist:

- eine Einrichtung zum Setzen des Überwachungssignals auf einen Aktivzustand, wenn eine zwischen dem Ausgang und einem Referenzpotenzial anliegende Ausgangspanung geringer als ein vordefinierter Aktivierungsschwellwert ist und/oder zum Setzen des Überwachungssignals auf einen Aktivzustand, wenn eine zwischen dem Ausgang und einem Referenzpotenzial anliegende Ausgangspanung größer als ein vordefinierter Aktivierungsschwellwert ist,
- eine Einrichtung zum Starten eines (kurzen) Verzögerungszeitnehmers (timers) damit der aktiv Zustand im RESET Signal erst nach einer definierten Filterzeit wirksam wird;
- eine Einrichtung zum Bringen des Überwachungssignals in einen Inaktivzustand, falls die Ausgangsspannung keine Aktivierungsschwelle verletzt und eine zwischen dem Eingang und dem Referenzpotenzial anliegende Eingangsspannung der Energieversorgungsreglereinheit wieder über einen Rücksetzschwellwert gestiegen ist oder liegt; und
- Starten eines weiteren Verzögerungszeitnehmers damit der inaktiv Zustand im Überwachungssignal (RESET-Signal) erst nach einer definierten mindest RESET-Aktiv Dauer wirksam wird.

Unter einem Steuergerät kann vorliegend ein elektrisches Gerät verstanden werden, das Sensorsignale verarbeitet und in Abhängigkeit davon Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programmprodukt auf einem Computer oder einer Vorrichtung ausgeführt wird.

Unter einer autarken Versorgung eines Verbrauchers kann eine Versorgung, beispielsweise mit elektrischer Energie verstanden werden, die von einem Energieversorgungsnetz entkoppelt ist. Unter einem Energiespeicher kann beispielsweise ein Kondensator oder ein elektrochemischer Energiespeicher verstanden werden, der während eines Zeitraums einer Kopplung mit dem Energieversorgungsnetz aufgeladen wird und nach einer Entkopplung von dem Energieversorgungsnetz den Verbraucher unter Zuhilfenahme der Energieversorgungseinheit autark versorgen kann. Unter einer Energieversorgungsreglereinheit kann eine Einheit verstanden werden, die eine Anpassung einer elektrischen Spannung und/oder eines elektrischen Stroms an einem Eingang der Energieversorgungsreglereinheit entsprechend einer Anpassungsvorschrift an eine elektrische Spannung und/oder einen elektrischen Strom vornimmt, die/der an einem Ausgang der Energieversorgungsreglereinheit ausgegeben wird. Unter einer Überwachungseinheit kann eine Einheit verstanden werden, die eine Überwachung einer am Eingang und/oder Ausgang der Energieversorgungsreglereinheit anliegende Spannung vornimmt und ein entsprechendes Überwachungssignal ausgibt. Das Überwachungssignal kann beispielsweise ein digitales Signal sein und ferner beispielsweise dazu vorgesehen sein, einen Betrieb und/oder eine Funktion des Verbrauchers zu steuern, beispielsweise anzuhalten oder wieder zu starten. Unter einem Aktivzustand des Überwachungssignals kann ein Signalzustand verstanden werden, der einem Verbraucher anzeigt, dass ein Betrieb und/oder eine Funktion des Verbrauchers zu unterdrücken oder anzuhalten ist. Unter einem Inaktivzustand des Überwachungssignals kann ein Signalzustand verstanden werden, der einem Verbraucher signalisiert, dass ein Betrieb und/oder eine Funktion des Verbrauchers uneingeschränkt ausführbar ist. Als unterer Aktivierungsschwellwert der Regelausgangsspannung kann beispielsweise ein vordefinierter unterer Grenzwert einer Spannung verstanden werden, bei dessen Unterschreiten das Überwachungssignal in einen Zustand versetzt wird, der einem Verbraucher signalisiert, dass ein Betrieb oder eine Funktion des Verbrauchers gestoppt oder angehalten werden soll (Aktivzustand). Als oberer Aktivierungsschwellwert der Regelausgangsspannung kann beispielsweise ein vordefinierter oberer Grenzwert einer Spannung verstanden werden, bei dessen Überschreiten das Überwachungssignal in einen Zustand versetzt wird, der einem Verbraucher signalisiert, dass ein Betrieb oder eine Funktion des Verbrauchers gestoppt oder angehalten werden soll (Aktivzustand). Unter einem Referenzpotenzial kann beispielsweise ein Massepotenzial oder ein anderes Potenzial in der Energieversorgungseinheit verstanden werden, welches als Referenz für die Messung einer Spannung an weiteren Anschlüssen oder Kontakten von Elementen der Energieversorgungseinheit dient.

Unter einem Rücksetzschwellwert der Reglereingangsspannung kann beispielsweise ein vordefinierter Grenzwert einer Spannung verstanden werden, der ein Hinweis darauf gibt, dass der Energiespeicher wieder geladen wird oder geladen wurde, sodass wieder elektrische Energie zur Verfügung steht, um einen Betrieb oder eine Funktion des Verbrauchers sicherzustellen oder für zumindest eine vor bestimmte Zeitspanne zu ermöglichen (wobei das Überwachungssignal abhängig von weiteren Bedingungen in einen Inaktivzustand gebracht wird).

Der hier vorgestellte Ansatz basiert auf der Erkenntnis, dass im Falle einer autarken Versorgung des Verbrauchers, durch die sich aufbrauchende gespeicherte Energie ein fehlerfreier Betrieb oder eine fehlerfreie Funktion nicht mehr sichergestellt werden kann, vermieden werden muss, dass ein wiederholter Signalwechsel des Überwachungssignals mit in Folge einer periodisch schwankenden Ausgangsspannung, die zu Fehler/Störungen beim Verbraucher führt, auftritt.

Wenn im Falle einer autarken Versorgung des Verbrauchers die im Energiespeicher gespeicherte Energie für einen fehlerfreien Betrieb oder eine fehlerfreie Funktion des Verbrauchers nicht mehr ausreicht, wird durch die Ausgabe des Überwachungssignals eine Funktion oder der Betrieb des Verbrauchers gestoppt. Dies jedoch würde dazu führen, dass durch eine Reduktion eines Stromflusses über die Energieversorgungsreglereinheit unter Berücksichtigung des Innenwiderstands der Energieversorgungsreglereinheit ein Abfall einer Spannung zwischen dem Eingang und dem Ausgang der Energieversorgungsreglereinheit resultiert, der bei einer alleinigen Überwachung bzw. einer Deaktivierung des Überwachungssignals auf Basis der Ausgangsspannung dazu führen könnte, dass die Ausgangsspannung wieder den unteren Aktivierungsschwellwert überschreitet und somit das Überwachungssignal zurückgesetzt wird. Reaktiviert nun der Verbraucher wieder seinen Betrieb oder eine Funktion, hätte dies zur Folge, dass die Ausgangsspannung durch den nun einsetzenden Stromfluss über die Energieversorgungsreglereinheit wieder unter den Aktivierungsschwellwert fällt und somit das Überwachungssignal wieder aktiviert würde. Es würde dadurch zum Betrieb des Verbrauchers mit einer periodisch schwankenden Versorgung kommen (Fehler / Störung - Gefahr). Wird nun dagegen eine Deaktivierung des Überwachungssignals unter zusätzlicher Auswertung der Eingangsspannung der Energieversorgungsreglereinheit vorgenommen, können solche periodische Vorgänge vermieden werden.

Der hier vorgestellte Ansatz bietet den Vorteil, dass durch das Vermeiden von wiederholten Wechseln im Überwachungssignal bei langsam abnehmender Eingangsspannung der Energieversorgungsreglereinheit (Energieabbau im Energiespeicher), ein Betrieb oder eine Funktion eines Verbrauchers mit periodisch schwankender Eingangsspannung unterbleibt, was insgesamt eine robustere und zuverlässigere Arbeitsweise des Verbrauchers / Funktion bis zur Abschaltung sicherstellt.

Gemäß einer vorteilhaften Ausführungsform der vorliegenden Erfindung kann die Überwachungseinheit ausgebildet sein, um das Überwachungssignal dann auf einen Aktivzustand zu setzen, die Eingangsspannung niedriger als ein zweiter Aktivierungsschwellwert (= Schwellwert der Eingangsspannung der Energieversorgungsreglereinheit) ist, insbesondere wobei der zweite Aktivierungsschwellwert gleich dem Rücksetzschwellwert ist. Eine derartige Ausführungsform der vorliegenden Erfindung bietet den Vorteil, dass sich durch technisch einfache Mittel sicherstellen lässt, dass eine Aktivierung des Überwachungssignals dann erfolgt, wenn alternativ oder zusätzlich zu dem Unterschreiten der Ausgangsspannung unter den Aktivierungsschwellwert die Eingangsspannung der Energieversorgungsreglereinheit niedriger als ein vordefinierter Grenzwert (als zweiter Aktivierungsschwellwert) ist. Hierdurch kann alternativ oder zusätzlich zur vorstehend genannten Aktivierungsbedingung für das Überwachungssignal berücksichtigt werden, dass bei einem bekannten maximalen Spannungsabfall über die Energieversorgungsreglereinheit das Überwachungssignal dann aktiviert, d. h. in den Aktivzustand gesetzt wird, wenn zwar die Ausgangsspannung (beispielsweise durch einen Betrieb des Verbrauchers außerhalb des Volllastbereichs) noch nicht die Aktivierungsschwelle unterschritten hat, jedoch bereits die Eingangsspannung an der Energieversorgungsreglereinheit durch das Unterschreiten unter den zweiten Aktivierungschwellwert einen Rückschluss ermöglicht, dass ein am Ausgang angeschlossener Verbraucher nicht mehr in Volllast betrieben werden könnte.

Günstig ist ferner eine Ausführungsform der vorliegenden Erfindung, bei der die Überwachungseinheit zumindest eine Digitalschaltung, insbesondere eine Logikschaltung aufweist, um das Überwachungssignal zu erzeugen. Eine derartige Ausführungsform der vorliegenden Erfindung bietet den Vorteil, durch technisch sehr einfache Mittel das Überwachungssignal bereitstellen zu können, welches eindeutige Signalzustände zur Steuerung oder Regelung eines am Ausgang der Energieversorgungsreglereinheit angeschlossenen Verbrauchers ermöglicht.

Vorteilhaft ist auch eine Ausführungsform der vorliegenden Erfindung, bei der die Überwachungseinheit zumindest ein rücksetzbares Flipflop-Element, insbesondere ein D-Flipflop aufweist, um das Überwachungssignal zu erzeugen. Ein derartiges Element zu Erzeugung des Überwachungssignals, insbesondere wobei das Überwachungssignal an einem Ausgang eines solchen Flipflop-Elements abgegriffen oder von einem Signal eines Ausgangs eines solchen Flipflop-Elements abgeleitet wird, lässt sich technisch einfach und kostengünstig implementieren.

Um den Aktivzustand des Überwachungssignals auch nach Erkennung korrekter Verhältnisse an der Energieversorgungsreglereinheit (Eingangs- und Ausgangsspannung sind richtig) eine bestimme Zeitdauer weiter aufrechtzuerhalten, kann gemäß einer günstigen Ausführungsform der vorliegenden Erfindung, die Überwachungseinheit zumindest ein digitales Element aufweisen, dass mit einem definierten Taktsignal (CLK) getaktet wird oder in Abhängigkeit von der Ausgangsspannung getaktet ist (Zähler etc.).

Gemäß einer weiteren Ausführungsform der vorliegenden Erfindung kann die Überwachungseinheit zumindest ein digitales Element aufweisen, das in Abhängigkeit von der Eingangsspannung der Energieversorgungsreglereinheit rückgesetzt wird. Eine solche Ausführungsform der vorliegenden Erfindung bietet den Vorteil, dass sich die gespeicherte von der Ausgangsspannung der Energieversorgungsreglereinheit unabhängige Aktivierung des Überwachungssignals wieder aufgehoben (rückgesetzt) wird.

Um besonders robust sicherzustellen, dass nur ein wirkliches Absinken der Ausgangsspannung der Energieversorgungsreglereinheit und keine Transienten das Überwachungssignal aktivieren, wird gemäß einer Ausführungsform der vorliegenden Erfindung die Überwachungseinheit ausgebildet, um bei einem Wechsel des Überwachungssignals von einem ersten Zustand zu einem zweiten Zustand die Ausgabe des Überwachungssignals im zweiten Zustand um eine vordefinierte Zeitdauer zu verzögern und bei einem Wechsel des Überwachungssignals von dem zweiten Zustand zu dem ersten Zustand die Ausgabe des Überwachungssignals im ersten Zustand nicht zu verzögern.

Besonders vorteilhaft ist eine Ausführungsform der vorliegenden Erfindung als Personensicherheiteinheit für ein Fahrzeug mit einer Insassen- und/oder Verkehrsteilnehmerschutzvorrichtung, die als Verbraucher mit der Energieversorgungseinheit gemäß einer hier beschriebenen Variante gekoppelt ist. Eine Insassenschutzvorrichtung kann beispielsweise ein Steuergerät für einen Airbag, einen Gurtstraffer oder ein anderes Element zum Verbau in ein Fahrzeug sein, welches eine Sicherheit oder einen Schutz eines Insassen des Fahrzeugs bei einem Unfall erhöht. Eine Verkehrsteilnehmerschutzvorrichtung kann beispielsweise eine Vorrichtung sein, die einen Verkehrsteilnehmer schützt, der sich außerhalb des Fahrzeugs befindet. Beispielsweise kann ein solcher Verkehrsteilnehmer ein Fußgänger, ein Fahrradfahrer, ein Motorradfahrer oder dergleichen sein. Insbesondere kann ein solcher Verkehrsteilnehmer als ein unterlegener Straßennutzer verstanden werden, der in Bezug auf ein Fahrzeug wie beispielsweise ein Pkw, ein Lkw oder allgemein ein mehrspuriges Fahrzeug schwächer oder verletzlicher ist. Beispielsweise kann eine solche Verkehrsteilnehmerschutzvorrichtung einen Außenairbag, eine Motorabdeckungsaufstellungsvorrichtung oder dergleichen umfassen, um den Schutz des Verkehrsteilnehmers bei einem Aufprall mit dem Fahrzeug zu erhöhen. Eine solche Ausführungsform der vorliegenden Erfindung bietet den Vorteil, dass eine Betriebssicherheit der Insassenschutzvorrichtung durch eine Warnung vor einem Abfall einer Versorgungsspannung der Insassenschutzvorrichtung realisierbar ist, insbesondere wenn das Überwachungssignal zur Steuerung eines Betriebs oder einer Funktion der Insassenschutzvorrichtung verwendet wird.

Die Erfindung wird nachstehend anhand der beigefügten Zeichnungen beispielhaft näher erläutert. Es zeigen:

Fig. 1A   einen Schaltplan einer Energieversorgungseinheit für einen Verbraucher;

Fig. 1B   Diagramme von Signalen einer gemäß Fig. 1A aufgebauten Energieversorgungseinheit über einen Zeitverlauf;

Fig. 2A   einen Schaltplan einer Energieversorgungseinheit für einen Verbraucher gemäß einem Ausführungsbeispiel der vorliegenden Erfindung;

Fig. 2B   Diagramme von Signalen einer gemäß Fig. 2A aufgebauten Energieversorgungseinheit entsprechend einem Ausführungsbeispiel der vorliegenden Erfindung;

Fig. 2C   Diagramme von weiteren Signalen einer gemäß Fig. 2A aufgebauten Energieversorgungseinheit entsprechend einem Ausführungsbeispiel der vorliegenden Erfindung;

Fig. 3A   einen Schaltplan eines Ausführungsbeispiels einer Überwachungseinheit zur Verwendung in einer Energieversorgungseinheit für einen Verbraucher;

Fig. 3B   eine Tabelle, die einen Zusammenhang zwischen Eingangsgrößen und Ausgangsgrößen einer gemäß Fig. 3A aufgebauten Überwachungseinheit wiedergibt;

Fig. 3C   Diagramme von weiteren Signalen unter Verwendung einer gemäß Fig. 3A aufgebauten Überwachungseinheit entsprechend einem Ausführungsbeispiel der vorliegenden Erfindung;

Fig. 4A   einen Schaltplan eines weiteren Ausführungsbeispiels einer Überwachungseinheit zur Verwendung in einer Energieversorgungseinheit für einen Verbraucher;

Fig. 4B   eine Tabelle, die einen Zusammenhang zwischen Eingangsgrüßen und Ausgangsgrößen einer gemäß Fig. 4A aufgebauten Überwachungseinheit wiedergibt;

Fig. 4C   Diagramme von weiteren Signalen unter Verwendung einer gemäß Fig. 4A aufgebauten Überwachungseinheit entsprechend einem Ausführungsbeispiel der vorliegenden Erfindung; und

Fig. 5   ein Ablaufdiagramm eines Verfahrens gemäß einem Ausführungsbeispiel der vorliegenden Erfindung

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

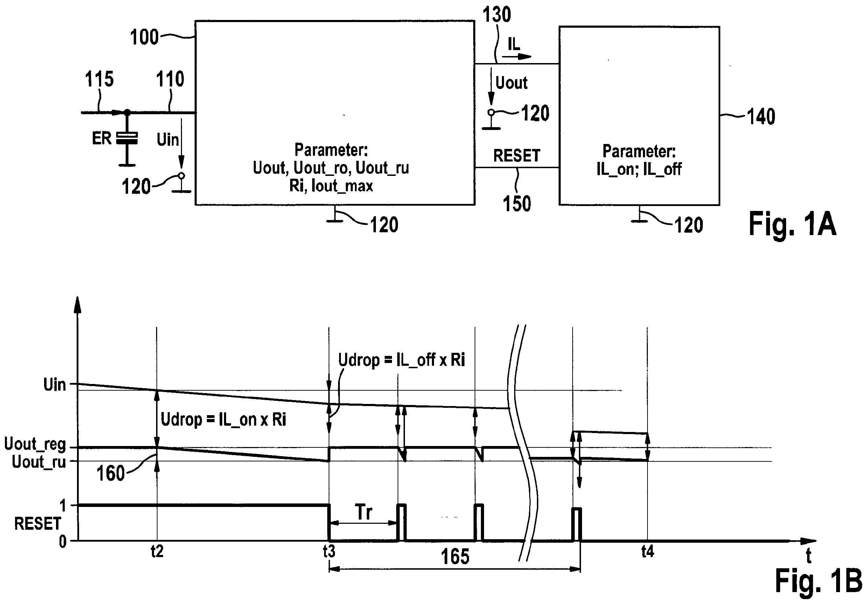

Fig. 1A zeigt zur Erläuterung des dem hier vorgestellten Ansatz zugrunde liegenden Problems ein Schaltbild eines durch eine Energiereserve ER gepufferten Spannungsreglers 100, der als P-MOSFET-Spannungsregler mit RESET-Überwachung und Strombegrenzung ausgelegt ist. Der Spannungsregler 100 wird von einer Energiereserve ER, beispielsweise einem Kondensator an einem Eingang 110 gespeist, wobei die Energiereserve ER durch ein Energieversorgungsnetz 115 geladen wird und nach einer Entkopplung des Energieversorgungsnetzes 115 eine autarke Versorgung des Spannungsreglers 100 übernimmt. Weiterhin fällt zwischen dem Eingang 110 und einem Referenzpotenzial 120, hier einem Massepotenzial, eine Eingangsspannung Uin ab. An einem Ausgang 130 des Spannungsreglers 100 wird eine geregelte Spannung Uout (bezogen auf das Referenzpotenzial 120) bei einem Ausgabestrom IL ausgegeben, der einen Gesamtstrom darstellt, der einer Summe von Verbrauchern 140 vom Spannungsregler 100 zur Verfügung gestellt werden kann. Dabei sind die Verbraucher 140 alle durch ein RESET-Signal, das als Überwachungssignal 150 vom Spannungsregler 100 ausgegeben wird, steuerbar. In der folgenden Beschreibung werden die Begriffe Überwachungssignal, RESET, RESET-Signal und RESET-Zustand verwendet, wobei diese Begriffe inhaltlich in Abhängigkeit vom Kontext als Signal oder als Wert des Überwachungssignals zu verstehen sind.

Wie aus den Diagrammen aus Fig. 1B zu entnehmen ist, verhält sich das in Fig. 1A dargestellte System im Autarkiefall, d. h. bei entkoppeltem Energieversorgungsnetz 115 wie folgt:

Die Eingangsspannung Uin des Spannungsreglers 100 fällt, wobei durch den Innenwiderstand Ri des Spannungsreglers 100 bei (fließendem) Strom IL_on auch ein Laststrom abhängiger Spannungsabfall (Spannungsdrop) über den Spannungsregler 100 zu verzeichnen ist, wenn er den Regelbereich verlässt. Hierdurch wird ab dem Zeitpunkt t2 die Ausgangsspannung Uout mit einer Spannungsdifferenz Udrop zur Eingangsspannung Uin fallen. Dabei wird die Ausgangsspannung zum Zeitpunkt t3 ein Abstand 160 zwischen der durch den Spannungsregler 100 eigentlich angestrebten Regelspannung Uout_reg zu einer (minimalen) Unterspannungsgrenze am Ausgang 130 durchschritten haben. Die Ausgangsspannung Uout des Spannungsreglers 100 verlässt somit den Regelbereich sobald

$$Uin < Uout\_reg + Ri \times IL\_on \text{ gilt.}$$

Beispielsweise verlässt die Ausgangsspannung Uout den Regelbereich bei IL = 1A, Ri = 1Ohm und Uout_reg = 6.7V ab Uin < 7.7V, wobei Ri den Innenwiderstand des P-Channel MOSFET-Reglers100 und IL_on die Summe der Verbrauchströme IL am Regler-Ausgang 130 bei inaktivem Überwachungssignal bezeichnet.

Die Eingangsspannung Uin des Reglers 100 kann weiter abnehmen, bis die Ausgangsspannung Uout die untere Spannungsüberwachungsgrenze Uout_ru der Reglerausgangsspannung Uout erreicht. Dann wird ein Low-aktives RESET Signal erzeugt, um einen Betrieb und/oder eine Funktion des oder der Verbraucher 140 zu verhindern oder auszuschalten, sodass dann lediglich ein Strom IL_off über den Ausgang 130 fließt. Für die RESET-Unterspannungsgrenze gilt z. B.: Uout_ru = Uout_reg - 200mV.

Die Eingangsbedingung des Reglers für die RESET-Aktivierung lässt sich wie folgt wiedergeben:

$$Uin \text{ (reset)} = Uout\_ru + IL\_on \times Ri = Uout\_reg - 200mV + 1V = 7.5V$$

Wenn das Überwachungssignal aktiviert ist (d. h. der RESET eintritt) hat dies eine synchrone Rückwirkung auf die Lastströme IL des Reglers 100. Beträgt der Laststrom während eines aktiven Überwachungssignals = RESET

$$IL\_off = k \times IL\_on \text{ (k = 0 ... 1) z. B. } 0.5 \times IL\_on,$$

folgt unmittelbar mit dem RESET wieder eine Spannungserhöhung am Reglerausgang 130.

Theoretisch beträgt diese Spannungserhöhung Ri x (IL_on - IL_off); für obiges Beispiel beträgt der Spannungserhöhungsbetrag 0.5V. Die Erhöhung wird aber durch den Regler auf die Regelspannung Uout_reg begrenzt.

Daher ist in der Darstellung aus Fig. 1B unmittelbar mit dem Eintritt der RESET-Bedingung (d. h. der Aktivierungsbedingung für das Überwachungssignal RESET) diese bereits wieder synchrone aufgehoben und der RESET-Zustand bleibt nur durch die jetzt ablaufende RESET-Dauer Tr limitiert erhalten. Auch während dieser Zeit nimmt die Eingangsspannung Uout ab, da keine neue Energie aus der Fahrzeugversorgung in der Form des Energieversorgungsnetzes der Energiereserve ER zugeführt wird und diese nun den Laststrom IL_off decken soll.

Ist am Ende der RESET-Monoflop-Zeit Tr die Eingangsspannung Uout des Spannungsreglers 100 auf die Bedingung

$$Uin \text{ (dauer\_reset)} = Uout\_ru + IL\_off \times Ri$$

(im Beispiel 7V) reduziert, bleibt der das Überwachungssignal RESET dauernd aktiv (Zeitpunkt t4), sonst wird das System wieder freigegeben und erneut resetiert. Daher kommt es wie in den Diagrammen aus Fig. 1B dargestellt zu wiederholten RESET inaktiv / aktiv Zuständen (auch als RESET-Pulsen bezeichnet), wie sie in der Zeitspanne 165 zu erkennen sind.

Ein wichtiger Aspekt des hier vorgeschlagenen Ansatzes kann darin gesehen werden, dass Auftreten mehrmaliger RESET-Pulse, als Folge eines synchron zum ausgelösten RESET reduzierten Reglerstromes IL, in gepufferten Systemen zu verhindern. Dadurch werden Instabilitäten beim Ausschalten von Rückhaltesystemen wie Airbags bzw. deren Steuergeräte als Verbraucher 140 vermieden, da die erneute RESET-Freigabe gerade in einem Bereich nicht geregelter Spannungsänderung des Regler-Ausgangs 130 erfolgt (Bereich zwischen Unterspannungs-RESET-Schwelle Uout_ru und Regelspannung Uout_reg).

Es soll somit durch den hier vorgeschlagenen Ansatz eine stabile RESET-Vorgabe (d. h. eine stabile Aktivierungsvorgabe zur Aktivierung des Überwachungssignals RESET) auch bei synchrone zum aktiven RESET fallenden Reglerausgangsstromes IL ermöglicht werden.

Der hier vorgeschlagene Ansatz sieht einen durch die Energiereserve ER gepufferten Spannungsregler 100 mit Über- und Unterspannungsüberwachung der Ausgangsspannung und zusätzlicher Schwellenüberwachung der Reglereingangsspannung vor, derart, dass beim Auftreten einer zu niedrigen Ausgangspannung Uout_ru (= untere garantierte Spannung bei der alle angeschlossenen Verbraucher 140 noch nach Spezifikation voll funktionieren) dieser Zustand gespeichert wird, wenn zusätzlich auch die Regler - Eingangsspannung kleiner ist wie Uin_min (= untere garantierte Reglereingangsspannung Uin bei der der Regler 100 die nominale Ausgangsspannung Uout unter voller Stromlast IL (= Iout_max) nach Spezifikation noch bereitstellen kann).

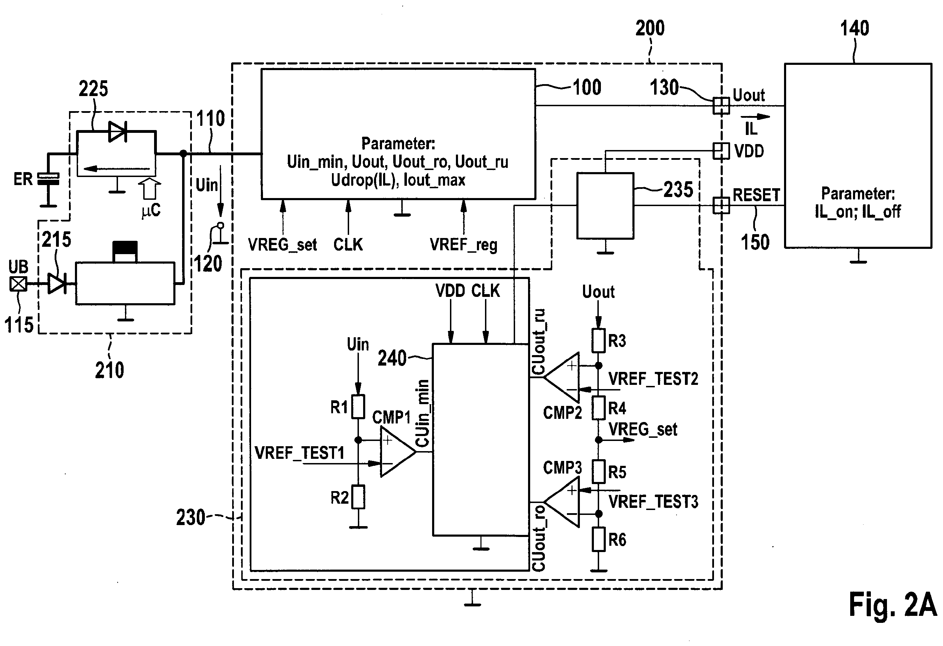

Fig. 2A zeigt ein Schaltbild eines durch eine Energiereserve gepufferten Spannungsreglers 100 mit laststromunabhängiger RESET-Generierung entsprechend dem hier vorgestellten Ansatz. Hierbei ist der Spannungsregler 100 Teil einer Energieversorgungseinheit, die ferner die Energiereserve ER und eine Überwachungseinheit 200 aufweist, die ausgebildet ist, um das Überwachungssignal RESET auszugeben. Der Eingang der Energieversorgungseinheit 200, der auch den Eingang des Spannungsreglers 200 bildet (der auch als Energieversorgungsregeleinheit bezeichnet werden kann), ist über eine Versorgungsschaltung 210 mit der Energiereserve ER und dem Energieversorgungsnetz 115 verbunden, wobei ein Gleichrichtungselement 215 elektrische Energie von dem Energieversorgungsnetz 115 zu einer Up-Converter-Schaltung 220 führt, die wiederum mit dem Eingang 110 des Spannungsreglers 110 verbunden ist. Weiterhin verbindet zusätzlich eine durch einen Mikrocontroller μC gesteuerte Ladeschaltung 225 mit steuerbarem Stromfluss den Up-converter 220 mit der Energiereserve ER (im Ladebetrieb). Außerdem verbindet elektrisch eine Diode (Anode an der Energiereserve ER) diese mit dem Eingang 110 zur Stromabgabe im Autarkiefall. Der Ausgang der Energieversorgungseinheit 200, der auch der Ausgang des Spannungsreglers 100 ist, ist wiederum mit dem oder den Verbraucher(n) 140 verbunden.

Im Unterschied zu dem Spannungsregler 100, wie er in der Fig. 1A dargestellt wurde, wird nun das Überwachungssignal 150 (RESET) von einer Überwachungseinheit 230 mit einem Treiber 235 geliefert. Die Überwachungseinheit 230 überwacht die Eingangsspannung Uin, die Ausgangsspannung Uout und ermittelt hieraus unterschiedliche Zwischensignale, die für die Ermittlung des Überwachungssignals RESET herangezogen werden. Beispielsweise wird ein erstes Zwischensignal CUin_min ermittelt, in dem die Eingangsspannung Uin an einen Spannungsteiler mit den Widerständen R1 und R2 gelegt wird, wobei der Abgriffspunkt zwischen den Widerständen R1 und R2 elektrisch leitend mit einem nicht-invertierenden Eingang eines ersten Komparators CMP1 gelegt wird. Der invertierende Eingang des ersten Komparators CMP1 wird mit einer ersten Referenzspannung VREF_TEST1 verbunden, die zusammen mit dem Teilerverhältnis (R1+R2)/R2 beispielsweise dem nachfolgend noch näher beschriebenen Rücksetzschwellwert (= VREF_TEST1 * (R1+R2)/R2) entspricht. Am Ausgang des ersten Komparators CMP1 lässt sich dann das erste Zwischensignal CUin_min abgreifen, das einen hohen Signalpegel (d. h. logisch "1") aufweist, wenn die Eingangsspannung Uin größer als der Rücksetzschwellwert ist.

Die Ausgangsspannung Uout wird über einen Spannungsteiler mit den vier in Reihe geschalteten Widerständen R3, R4, R5 und R6 gelegt. Der Abgriffspunkt zwischen den Widerständen R3 und R4 wird elektrisch leitend mit einem nicht-invertierenden Eingang eines zweiten Komparators CMP2 gelegt. Der invertierende Eingang des zweiten Komparators CMP2 wird mit einer zweiten Referenzspannung VREF_TEST2 verbunden, wobei an einem Ausgang des zweiten Komparators CMP2 ein zweites Zwischensignal CUout_ru abgegriffen werden kann. Am Ausgang des zweiten Komparators CMP2 lässt sich dann das zweite Zwischensignal CUout_ru abgreifen, das einen hohen Signalpegel (d. h. logisch "1") aufweist, wenn die Ausgangsspannung Uout des Reglers größer ist als ein unterer noch zulässiger Grenzwert.(Uout_ru).

Der Abgriffspunkt zwischen den Widerständen R5 und R6 wird elektrisch leitend mit einem invertierenden Eingang eines dritten Komparators CMP3 verbunden. Der nicht invertierende Eingang des dritten Komparators CMP3 wird mit einer dritten Referenzspannung VREF_TEST3 verbunden, wobei an einem Ausgang des dritten Komparators CMP3 ein drittes Zwischensignal CUout_ro abgegriffen werden kann.

Am Ausgang des dritten Komparators CMP2 lässt sich dann das zweite Zwischensignal CUout_ro abgreifen, das einen hohen Signalpegel (d. h. logisch "1") aufweist, wenn die Ausgangsspannung Uout des Reglers kleiner ist als ein oberer noch zulässiger Grenzwert. (Uout_ro).

Die erste, zweite und dritte Referenzspannung VREF_TEST1, VREF_TEST2, bzw. VREF_TEST3 können auch gleiche Werte annehmen.

An einem Abgriffspunkt zwischen den Widerständen R4 und R5 kann ein viertes Zwischensignal VREG_set abgegriffen werden.

Das erste Zwischensignal CUin_min, das zweite Zwischensignal CUout_ru und das dritte Zwischensignal CUout_ro werden nun neben einer Versorgungsspannung VDD und einem Taktsignal CLK einer Digitalschaltung 240 zur Verfügung gestellt, die beispielsweise ein oder mehrere Logikelemente, Zähler, Flipflop oder dergleichen aufweist, um das durch den Treiber 235 verstärkte Überwachungssignal RESET bereitstellen zu können, wie es nachfolgend noch näher beschrieben wird.

Zur weiteren Erläuterung der Funktionsweise der Überwachungseinheit 230 soll noch auf die folgenden Signale näher eingegangen werden:

Unter VREF_TEST (d. h. VREF_TEST1, VREF_TEST2 bzw. VREF_TEST3) wird/werden hier eine oder mehrere Referenzspannungspegel zur Spannungsüberwachung zusammengefasst. Diese werden bei separaten Spannungsreglern aus Uin oder bei integrierten Systembausteinen aus einer geeigneten Systemspannung über eine Vorstabilisierung mit Bandgap erzeugt, was in dieser Beschreibung nicht näher thematisiert werden soll.

Unter der Variable CLK wird vorliegend ein Clocksignal (d. h. Taktsignal) zur Erzeugung eines notwendigen Reglertaktes (falls ein Schaltregler verwendet wird) und zur Erzeugung einer definierten RESET-Nachlaufzeit beim Übergang der Regler Ausgangs- und Eingangsbedingungen in den "GUT" Zustand bzw. zur Erzeugung von Filterzeiten bezeichnet.

Die Bezeichnung VDD repräsentiert eine Hilfsspannung zur Versorgung der Logik 240.

Die Variable VREG_set bezeichnet eine Reglerrückführungsspannung (Ist-Wert von Uout).

Die Variable VREF_REG bezeichnet eine Referenzspannung zur Spannungsregelung. Wird bei separaten Spannungsreglern aus Uin oder bei integrierten Systembausteinen aus einer geeigneten Systemspannung über eine Vorstabilisierung mit Bandgap erzeugt, was in dieser Beschreibung nicht näher thematisiert werden soll.

Insbesondere durch die Elemente R1, R2, CMP1, Uin, VREF_test ist eine Schaltung zur Überwachung der Spannung Uin auf eine definierte Schwelle (Uin min) beschrieben, bei der CUin min = "high"gilt, wenn Uin > Uin min und CUin min = "low" gilt, wenn Uin <= Uin min.

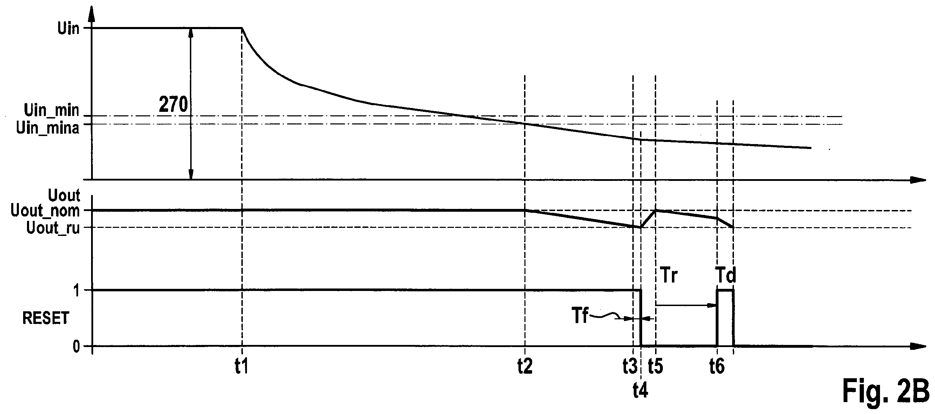

In der Fig. 2B sind Diagramme von Signalverläufen von einzelnen Signalen wiedergegeben, die in dem Schaltplan aus der Fig. 2A dargestellt sind. Hierbei ist insbesondere der zeitliche Verlauf der Eingangsspannung Uin, der zeitliche Verlauf der Ausgangsspannung Uout und der zeitliche Verlauf des Überwachungssignal RESET dargestellt.

Zu einem ersten Zeitpunkt t1 erfolgt (ausgehend von einem Zustand 270 der Normalversorgung durch das Energieversorgungsnetz) ein Beginn der abnehmenden Versorgung eines gepufferten Reglers z. B. im Fall einer einsetzenden Autarkie. Zum zweiten Zeitpunkt t2 unterschreitet die Eingangsspannung Uin eine individuelle (vom Regler-Innenwiderstand Ri und einer am Regler 100 anliegenden Lasthöhe abhängige) Schwelle Uin_mina (application), bei der die Ausgangsspannung Uout nicht mehr auf dem Regelwert Uout_nom (nominal) gehalten werden kann. Ab dem dritten Zeitpunkt t3 unterschreitet die Ausgangsspannung Uout den Wert Uout_ru und damit die Schwelle, bei der das Überwachungssignal RESET nach einer Filterzeit Tf ausgelöst wird, (d. h. ein Signalwechsel des Überwachungssignals auf den Zustand "low" erfolgt). In einem vierten Zeitpunkt t4 ist das Überwachungssignal RESET ausgelöst (d. h. aktiviert und im Zustand "low") und die Stromlast des Reglers wird reduziert von IL_on auf IL_off, wodurch bei geringerem Regler-Drop die Ausgangsspannung Uout wieder auf die nominale Reglerspannung Uout_nom steigt (steigen kann je nach Applikation). Zu einem fünften Zeitpunkt t5 wird mit der Wiederherstellung einer Reglerspannung größer als Uout_ru die RESET-Nachlaufzeit Tr getriggert und bei geringer Abnahme der Eingangsspannung Uout aufgrund stark reduzierter Last der RESET zum Zeitpunkt t6 wieder freigegeben. Im Zeitpunkt t6 ist die logische Monoflopzeit Tr (d. h. die RESET-Nachlaufzeit) abgelaufen und der RESET wird wieder freigegeben. Der reduzierte Laststrom wird verzögert für den Regler (Deckung aus dem Ausgangskondensator des Reglers) auf Nominalstrom erhöht, wodurch sich der Drop über den Regler erhöht und RESET Bedingungen wie zum Zeitpunkt t3 einstellen. Diese Vorgänge wiederholen sich bis nicht Uin≤Uout_ru + Udrop@IL_off.

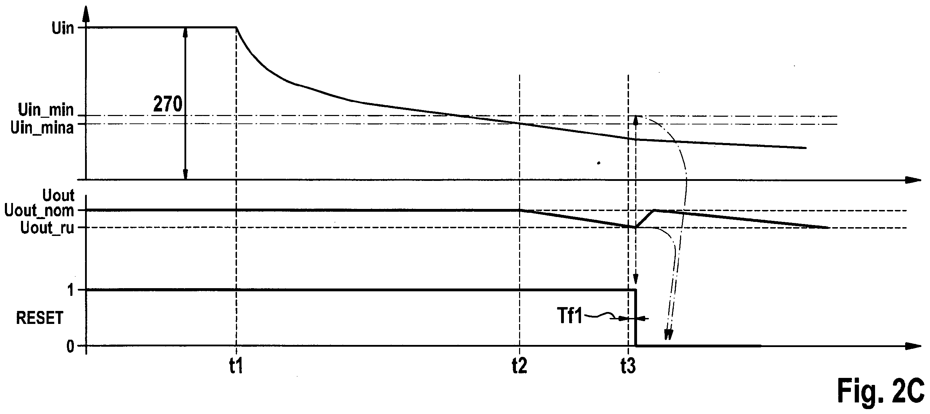

Fig. 2C zeigt weitere Ablaufdiagramme von Signalpegelwerten der Eingangsspannung, der Ausgangsspannung und des Überwachungssignals als Eigenschaften der hier vorgestellten Energieversorgungseinheit. Gemäß einem Ausführungsbeispiel der vorliegenden Erfindung ist nun in der RESET-Logik 240 entsprechend dem Schaltbild aus Fig. 2A Folgendes neu vorgesehen. Wird zum Zeitpunkt t3 eine Unterspannung in der Ausgangsspannung Uout erkannt (d. h. = CUout_ru = 0 oder "low"), so wird dieser Zustand nach einer Filterzeit (Tf1 >= 0) gespeichert, falls zu diesem Zeitpunkt auch die neu hinzugefügte Überwachung der Eingangsspannung Uin eine zu niedrige Eingangsspannung signalisiert (d. h. CUin_min = 0; Uin <= Uin_min)). Diese gespeicherte Unterspannungsreset-Bedingung bleibt solange wirksam, bis nicht die Eingangsspannung Uin den Wert Uin_min wieder überschreitet. Wird die Eingangsspannung über Uin_min hinaus erhöht, wird der gespeicherte Wert in der RESET Logik zur Bildung des Überwachungssignals RESET zurückgesetzt oder deaktiviert.

Die RESET-Bedingung (Überwachungssignal RESET) hängt nun wieder allein von der Überwachung der Ausgangsspannung Uout ab. Ist die Ausgangsspannung Uout im Überwachungsband (CUout_ru = 1; CUout_ro = 1) wird ein Monoflop (auch digitales Element, Zähler etc.) zur RESET-Nachlaufzeit-Generierung getriggert. Ist die Nachlaufzeit abgelaufen, wird das RESET-Signal auf "nicht aktiv", d. h. auf logisch "1" gesetzt. Das heißt, die neue Überwachung der Eingangsspannung Uin spielt nur dann eine Rolle , wenn das RESET-Signal durch die Unterspannung am Regler-Ausgang 130 einen Fehler erkennt. Dann wird der "aktive" Zustand des Unterspannungsreset-Signals RESET (d. h. des Überwachungssignals) gespeichert, sobald auch noch die Eingangsspannung Uin des Reglers 130 niedriger wird, als zum Erzeugen einer korrekten Ausgangsspannung Uout unter voller Stromlast IL_max notwendig wäre. Der gespeicherte Zustand in der RESET Logik zur Bildung des Überwachungssignals RESET "aktiv" (= zu niedrige Reglereingangsspannung Uin<Uinmin und zu niedrige Reglerausgangsspannung Uout<Uout_ru) wird wieder sofort oder gefiltert aufgehoben, sobald die Eingangsspannung Uin größer als Uin_min wird. Dadurch ergeben sich keine Nachteile beim Start eines bisher unversorgten Reglers.

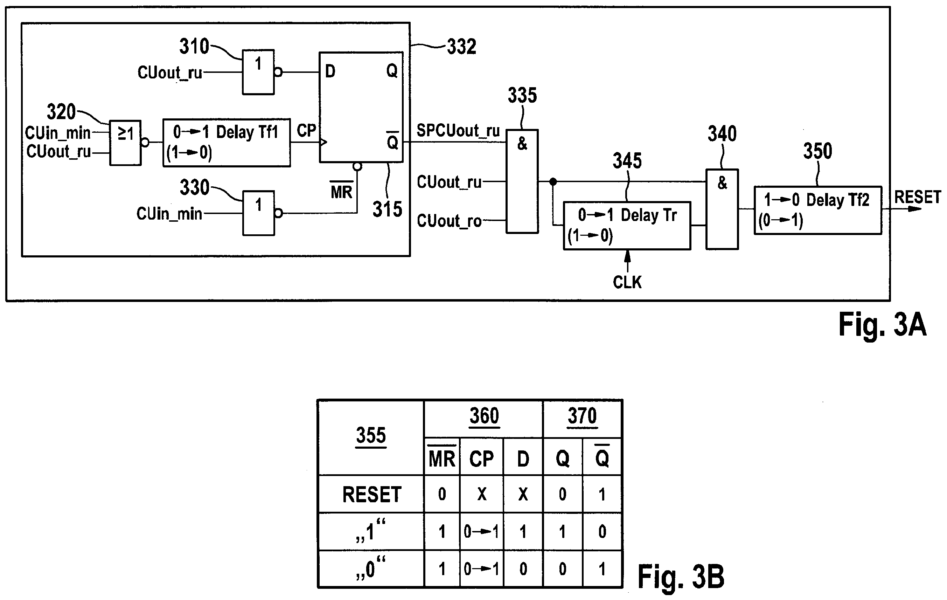

Fig. 3A zeigt ein Schaltbild eines Ausführungsbeispiels einer Überwachungseinheit 230 zur Verwendung in einer Energieversorgungseinheit gemäß einem Ausführungsbeispiel der vorliegenden Erfindung. Aus dem Schaltbild aus fig. 3A ist ersichtlich, dass gemäß diesem Ausführungsbeispiel der vorliegenden Erfindung das zweite Zwischensignal CUout_ru mittels eines Inverters 310 invertiert wird und das invertierte Zwischensignal CUout_ru dann einem D-Eingang eines D-Flipflops 315 zugeführt wird. Das erste Zwischensignal CUin_min und das zweite Zwischensignal CUout_ru werden je auf einen Eingang eines NOR-Gatters 320 geführt, wobei das Ausgangssignal des NOR-Gatters 320 in eine erste Verzögerungseinheit 325 geleitet wird, in der bei einem Wechsel von einem Signalpegel von logisch 0 auf logisch 1 eine um eine Zeitspanne Tf1 verzögerte Ausgabe eines Signals CP erfolgt, wogegen bei einem Signalwechsel von logisch 1 auf logisch 0 keine Verzögerung des Signalwechsels im Signal CP erfolgt. Das Signal CP wird auf den Takteingang des D-Flipflops 315 gefügt und dient zur Taktung des D-Flipflops 315. Das erste Zwischensignal CUin_min wird ferner einem zweiten Inverter 330 zugeführt, der das invertierte erste Zwischensignal CUin_min als Rücksetzsignal $\overline{MR}$ auf einen Rücksetzsignaleingang des D-Flipflops 315 führt. Der Inverter 310, das D-Flipflop 315, das NOR-Gatter 320, die erste Verzögerungseinheit 325 und der zweite Invertierer 330 bilden hierbei eine Logikschaltung 332, die ein Logiksignal SPCUout_ru bereitstellt. Dieses Logiksignal SPCUout_ru ist am invertierten Ausgang $\overline{Q}$ abgreifbar, welches dann neben dem zweiten und dritten Zwischensignal CUout_ru bzw. CUout_ro auf je einen Eingang eines AND-Gatters 335 geführt wird. Der Ausgang des AND-Gatters 335 auf einen ersten Eingang eines zweiten AND-Gatters 340 geführt, wobei auf den zweiten Eingang des zweiten AND-Gatters 340 ein Signalpegel eines Ausgangs eines zweiten, durch ein Taktsignal CLK getaktetes Verzögerungselement 345 geführt ist. Dieses zweite Verzögerungselement 345 verzögert ein Signal am Ausgang des AND-Gatters 335 um eine Zeitspanne Tr, wenn ein Wechsel des Pegels am Ausgang des AND-Gatters 335 von einem Wert von logisch 0 auf logisch 1 erfolgt und wobei das Signal am Ausgang des AND-Gatters 335 nicht verzögert wird, wenn ein Wechsel des Pegels am Ausgang des AND-Gatters 335 von einem Wert von logisch 1 auf logisch 0 erfolgt. Ein Signal, das am Ausgang des weiteren AND-Gatters 340 abgegriffen werden kann, wird dann unter Verwendung einer dritten Verzögerungseinheit 350 um eine Zeitspanne Tf2 verzögert, wenn ein Wechsel des Pegels am Ausgang des dritten AND-Gatters 350 von einem Wert von logisch 1 auf logisch 0 erfolgt und wobei das Signal am Ausgang des dritten AND-Gatters 350 nicht verzögert wird, wenn ein Wechsel des Pegels am Ausgang des dritten AND-Gatters 350 von einem Wert von logisch 0 auf logisch 1 erfolgt. Das von der dritten Verzögerungseinheit 350 ausgegebene Signal kann dann als Überwachungssignal RESET verstanden werden, welches durch den Treiber 235 verstärkt und an entsprechende Verbraucher 140 abgegeben wird.

Unter Berücksichtigung der folgenden Zusammenhänge

$$Uout > Uout\_ru \quad \rightarrow CUout\_ru = 1$$
$$Uout \leq Uout\_ru \quad \rightarrow CUout\_ru = 0$$
$$Uout \geq Uout\_ro \quad \rightarrow CUout\_ro = 0$$
$$Uout < Uout\_ro \quad \rightarrow CUout\_ro = 1$$
$$Uin > Uin\_min \quad \rightarrow CUin\_min = 1$$
$$Uin \leq Uin\_min \quad \rightarrow CUin\_min = 0$$

$$RESET = 0 \quad \rightarrow Reset\ aktiv$$
$$RESET = 1 \quad \rightarrow Reset\ inaktiv$$

gelten der in der Tabelle aus Fig. 3B dargestellten Zusammenhänge für die angestrebte Funktion 355, die Eingänge 360 des D-Flipflops 315 und die Ausgänge 370 des D-Flipflops 315 wiedergegeben ist.

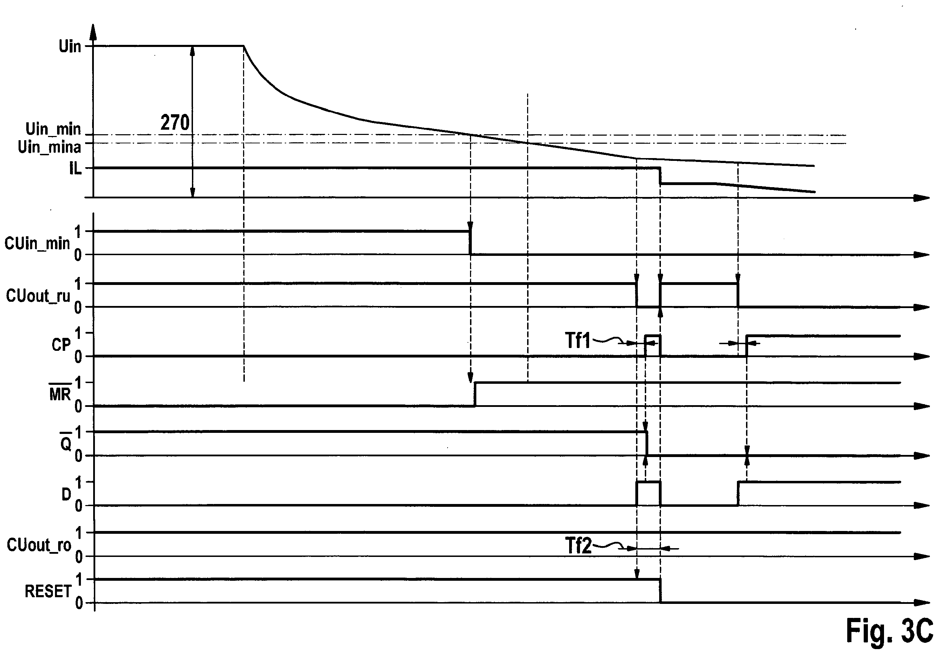

Fig. 3C zeigt Ablaufdiagramme zu Signalpegeln der Signale Uin, CUin_min, CUout_ru, CP, $\overline{MR}$, $\overline{Q}$, D, CUout_ro und RESET, die bei einer Auslegung und Verschaltung von Komponenten entsprechend der Darstellung aus der Fig. 3A resultieren.

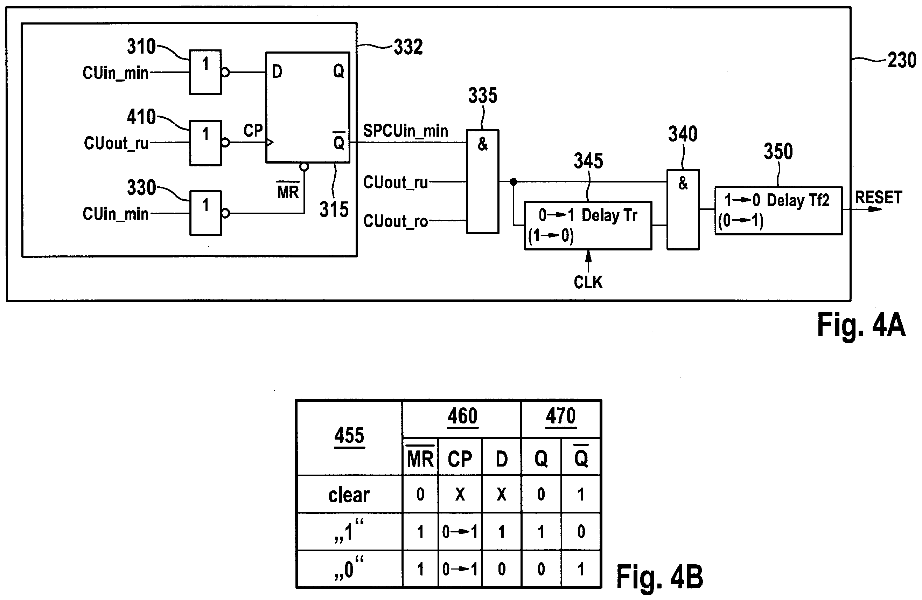

Fig. 4A zeigt einen Schaltplan eines weiteren Ausführungsbeispiels für eine Überwachungseinheit 230 zur Verwendung in einem Ausführungsbeispiel eine Energieversorgungseinheit. Im Unterschied zu dem in Fig. 3A gezeigten Schaltplan des Ausführungsbeispiels der Überwachungseinheit 230 ist nun die Logikeinheit 332 anders aufgebaut. Insbesondere wird nun durch den ersten Inverter 310 das erste Zwischensignal CUin_min invertiert und dem D-Eingang des D-Flipflops 315 zugeführt. Weiterhin wird das zweite Zwischensignal CUout_ru durch einen weiteren Inverter 410 invertiert und als Taktsignal dem Takteingang des D-Flipflops 315 zugeführt. Das von der Logikschaltung 332 ausgegebene Signal, das nun als SPCUnin_min bezeichnet wird und ein Statussignal zur Überwachung der Eingangsspannung darstellt, wird nun zusammen mit dem zweiten und dritten Zwischensignal auf je einen Eingang des AND-Gatters 335 geführt.

Unter Berücksichtigung der folgenden Zusammenhänge

$$Uout > Uout\_ru \quad \rightarrow CUout\_ru = 1$$
$$Uout \geq Uout\_ru \quad \rightarrow CUout\_ru = 0$$
$$Uout \geq Uout\_ro \quad \rightarrow CUout\_ro = 0$$
$$Uout < Uout\_ro \quad \rightarrow CUout\_ro = 1$$
$$Uin > Uin\_min \quad \rightarrow CUin\_min = 1$$
$$Uin \leq Uin\_min \quad \rightarrow CUin\_min = 0$$

$$RESET = 0 \quad \rightarrow Reset\ aktiv$$
$$RESET = 1 \quad \rightarrow Reset\ inaktiv$$

gelten die nun in der Tabelle aus Fig. 4B dargestellten Zusammenhänge für die angestrebte Funktion 455 für den RESET-Zustand, die Eingänge 460 des D-Flipflops 315 und die Ausgänge 470 des D-Flipflops 315 wiedergegeben ist.

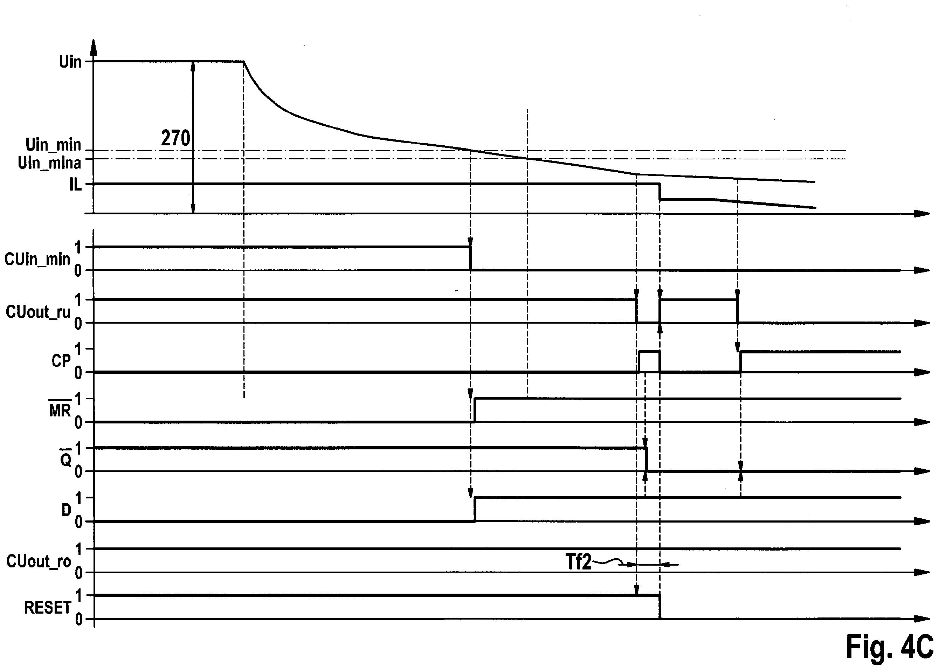

Fig. 4C zeigt Ablaufdiagramme zu Signalpegeln der Signale Uin, CUin_min, CUout_ru, CP, $\overline{MR}$, $\overline{Q}$, D, CUout_ro und RESET, die bei einer Auslegung und Verschaltung von Komponenten entsprechend der Darstellung aus der Fig. 4A resultieren.

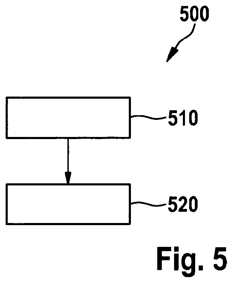

Fig. 5 zeigt ein Ablaufdiagramm eines Ausführungsbeispiels der vorliegenden Erfindung als Verfahren 500 zum Betrieb einer Energieversorgungseinheit gemäß einer vorstehend vorgestellten Variante zur autarken Versorgung eines Verbrauchers. Das Verfahren 500 umfasst einen Schritt 510 des Setzens des Überwachungssignals in einen Aktivzustand, wenn eine zwischen dem Ausgang und einem Referenzpotenzial anliegende Ausgangsspannung geringer als ein vordefinierter Aktivierungsschwellwert ist. Weiterhin umfasst das Verfahren 500 einen Schritt 520 des Bringens des Überwachungssignals in einen Inaktivzustand, wenn eine zwischen dem Eingang und dem Referenzpotenzial anliegende Eingangsspannung wieder über einen Rücksetzschwellwert gestiegen ist.

Zusammenfassend ist anzumerken, dass der in der Logikschaltung 332 gespeicherte Zustand (Uout <= Uout_ru) =S PCUout_ru (aktiv in "0" bei einer Auslegung der Logikschaltung 332 entsprechend dem Schaltplan aus Fig. 3A) steuert den externen RESET-Zustand auf aktiv (z. B. dargestellt durch eine logische "0"). Der durch die Logikschaltung 332 gespeicherte Zustand SPCUout_ru ist nicht direkt von der Ausgangsspannung Uout abhängig. Überschreitet die Reglerausgangsspannung Uout wieder die Grenze Uout_ru, ändert sich SPCUout_ru nicht zwangsläufig; d. h. auch bei korrekter Ausgangsspannung Uout des Reglers 100 wird RESET aktiv (= "0") ausgegeben.

Dies bleibt statisch solange erhalten, bis die Eingangsspannung Uin des Reglers 110 wieder die Grenze Uin_min überschreitet. Tritt dies ein, wird der gespeicherte Zustand auf inaktiv gesetzt (d. h., es besteht kein Einfluss auf den RESET mehr; SPCUout_ru ist somit unabhängig von Uout). Ist zu diesem Zeitpunkt die Ausgangsspannung Uout <= Uout_ru wird der externe RESET-Ausgang statisch auf aktiv ("0") gehalten. Überschreitet die Ausgangsspannung Uout die Grenze Uout_ru oder hatte diese bereits überschritten wird der RESET-Ausgang 150 nur noch für eine RESET-Nachlaufzeit Tr auf aktiv (d. h. "0") gehalten. Ist der RESET im inaktiven Zustand (d. h. "high") und SPCUout_ru (inaktiv, d. h. "1" in einer Verschaltung gemäß der Darstellung aus Fig. 3A), spielt die Überwachung der Eingangspannung Uin des Reglers 100 keine Rolle. Dies hat den Vorteil, dass im Autarkiefall die abnehmende Reglereingangsspannung Uin nicht von einer vordefinierten Grenze abhängig ist, sondern der RESET sich einstellt aufgrund der individuellen Regler und Lastparameter, die einen Drop über dem Regler 100 verursachen, der zum Unterschreiten einer auf den Ausgang 130 bezogenen Grenze führt.

Dadurch wird die Energiereserve ER individuell bis zur untersten Uin-Grenze genutzt. Beim Start des Systems ergeben sich keine Veränderungen oder im Gegenteil, die Reset-Nachlaufzeit kann kurz gehalten werden, da sie nicht mehr wichtig ist zur Verhinderung von mehrfachen RESET-Vorgängen ist. Die Eingangsspannung Uin des Reglers 100 wird unabhängig von der ER-Spannung schnell (< 2ms) durch einen Aufwärtswandler (Up-Converter gemäß fig. 2A) auf Spannungen von 20 ... 35 V gebracht. Dies hat den Vorteil, dass die für die RESET-Freigabe im Start (RESET ist bereits "low aktiv" aufgrund nicht vorhandener Ausgangsspannung) notwendige Überschreitung der worst case Eingangsspannung Uin des Reglers 100 zur Abgabe einer korrekten Ausgangsspannung Uout bei Vollast (ILmax) Uin_min keine längere Wartezeit nach sich zieht. Ferner ist die Lösung auch für Spannungsregler mit N-Channel MOSFETS oder NPN-Transistoren geeignet.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

**Patentansprüche**

1. Energieversorgungseinheit (200) zur autarken Versorgung eines Verbrauchers (140), wobei die Energieversorgungseinheit (200) folgende Merkmale aufweist:

   - einen Energiespeicher (ER), der zum Liefern von elektrischer Energie an einen Verbraucher (140) ausgebildet ist, wenn der elektrische Verbraucher (140) von einem Energieversorgungsnetz (115) entkoppelt ist;
   - eine Energieversorgungsreglereinheit (100) mit einem mit dem Energiespeicher (ER) gekoppelten Eingang (110) zur Aufnahme von elektrischer Energie und einem Ausgang (130) zur Abgabe von elektrischer Energie an den Verbraucher (140); wobei die Energieversorgungseinheit **dadurch gekennzeichnet ist, dass** sie weiterhin aufweist:

   - eine Überwachungseinheit (230) zur Ausgabe eines Überwachungssignals (150, RESET), wobei die Überwachungseinheit (230) ausgebildet ist, um das Überwachungssignal (150, RESET) auf einen Aktivzustand ("0") zu setzen, wenn eine zwischen dem Ausgang (130) und einem Referenzpotenzial (120) anliegende Ausgangsspanung (Uout) geringer als ein vordefinierter erster Aktivierungsschwellwert (Uout_ru) oder größer als ein vordefinierter zweiter Aktivierungsschwellwert (Uout_ro) ist, wobei die Überwachungseinheit (230) ferner so ausgebildet ist, um das Überwachungssignal (150, RESET) dann auf einen Inaktivzustand ("1") rück zu setzen, wenn eine zwischen dem Eingang (110) und dem Referenzpotenzial (120) anliegende Eingangspannung (Uin) wieder über einen Rücksetzschwellwert (Uin_min) steigt oder liegt.

2. Energieversorgungseinheit (200) gemäß Anspruch 1, **dadurch gekennzeichnet, dass** die Überwachungseinheit (230) ausgebildet ist, um das Überwachungssignal (150, RESET) im Aktivzustand ("0") unabhängig von einer Reglerausgangsspannungsüberwachung zu halten, wenn einmalig oder für ein bestimmtes Zeitfenster (Tf1) die Eingangsspannung (Uin) niedriger als ein dritter Aktivierungsschwellwert (Uin_min) und/oder die Ausgangsspannung (Uout) kleiner als der erste Aktivierungsschwellwert (Uout_ru) ist, insbesondere wobei der dritte Aktivierungsschwellwert (Uin_min) gleich dem Rücksetzschwellwert (Uin_min) ist.

3. Energieversorgungseinheit (200) gemäß einen der vorangegangenen Ansprüche, **dadurch gekennzeichnet, dass** die Überwachungseinheit (230) so ausgebildet ist, um das Überwachungssignal (150, RESET) in den Aktivzustand ("0") zu schalten, wenn die Eingansspannung (Uin) kleiner als die dritte Aktivierungsschwelle (Uin_min) ist, insbesondere wenn die unabhängig von einer Überwachung der Ausgangsspannung (Uout) der Energieversorgungsreglereinheit (100) von der Eingansspannung (Uin) kleiner als die dritte Aktivierungsschwelle ist, wobei insbesondere der dritte Aktivierungsschwellwert (Uin_min) so gewählt ist, dass die Ausgangsspannung (Uout) der Energieversorgungsreglereinheit (100) bis zu einem Spannungswert, der dem dritten Aktivierungsschwellwert (Uin_min) entspricht, auch unter voller Stromlast einen geregelten Spannungsbereich der Ausgangsspannung nicht verlässt.

4. Energieversorgungseinheit (200) gemäß einem der vorangegangenen Ansprüche, **dadurch gekennzeichnet, dass** die Überwachungseinheit (230) so ausgebildet ist, um das Überwachungssignal (150, RESET) in den Inaktivzustand ("1") zu schalten, falls die Eingangsspannung (Uin) größer oder gleich einem vordefinierten Rücksetzschwellwert ist, insbesondere wobei der Rücksetzschwellwert so gewählt ist, dass die Eingangsspannung (Uin) der Energieversorgungsreglereinheit (100) auch bei Vorliegen eines endlichen Innenwiderstandes des Energiespeichers durch ein Rücksetzen der Ausgangsspannung mit Folge einer Stromlastreduktion der Energieversorgungsreglereinheit (100) einen geregelten Eingangsspannungsbereich nicht verlässt, insbesondere wobei de Rücksetzschwellwert einem Wert entspricht, der sich durch die dritte Aktivierungsschwelle addiert um das Produkt aus dem maximalen Strom (ILonmax) mal dem Innenwiderstand (Ri) des Energiespeichers (ER) und/oder einer Dioden-Verbindung zum Eingang 110) der Energieversorgungsreglereinheit (100) bestimmen lässt.

5. Energieversorgungseinheit (200) gemäß einen der vorangegangenen Ansprüche, **dadurch gekennzeichnet, dass** die Überwachungseinheit (230) zumindest eine Digitalschaltung (240), insbesondere eine Logikschaltung aufweist, um das Überwachungssignal (150, RESET) zu erzeugen.

6. Energieversorgungseinheit (200) gemäß einen der vorangegangenen Ansprüche, **dadurch gekennzeichnet, dass** die Überwachungseinheit (230) zumindest eine Digitalschaltung (240), insbesondere eine Logikschaltung aufweist, die ausgebildet ist, um mit einem kontinuierlichen digitalen Taktsignal getaktet zu werden, um zumindest eine Nachlaufzeit zu bestimmen, in der ein Filter und/oder das Überwachungssignal (RESET) in dem Aktivzustandgehalten.

7. Energieversorgungseinheit (200) gemäß einen der vorangegangenen Ansprüche, **dadurch gekennzeichnet, dass** die Überwachungseinheit (230) ein oder mehrere rücksetzbare Flipflop-Elemente (315) insbesondere vom Typ D-Flipflop aufweist, um das Überwachungssignal (150, RESET) zu erzeugen.

8. Energieversorgungseinheit (200) gemäß einen der vorangegangenen Ansprüche, **dadurch gekennzeichnet, dass** die Überwachungseinheit (230) zumindest ein rücksetzbares Flipflop-Element (315) aufweist, welches in Abhängigkeit von der Eingangsspannung (Uin) rücksetzbar ist.

9. Energieversorgungseinheit (200) gemäß einen der vorangegangenen Ansprüche, **dadurch gekennzeichnet, dass die** Überwachungseinheit (230) zumindest ein rücksetzbares Flipflop-Element (315) aufweist, welches in Abhängigkeit von der Ausgangsspannung (Uout) und/oder der Eingangsspannung (Uin) taktbar ist.

10. Energieversorgungseinheit (200) gemäß einen der vorangegangenen Ansprüche, **dadurch gekennzeichnet, dass** die Überwachungseinheit (230) ausgebildet ist, um bei einem Wechsel des Überwachungssignals (150, RESET) von einem ersten Zustand ("1") zu einem zweiten Zustand ("0") die Ausgabe des Überwachungssignals (150, RESET) im zweiten Zustand ("0") um eine vordefinierte Zeitdauer (Tf2) zu verzögern und bei einem Wechsel des Überwachungssignals (150, RESET) von dem zweiten Zustand ("0") zu dem ersten Zustand ("1") die Ausgabe des Überwachungssignals (150, RESET) im ersten Zustand ("1") nicht zu verzögern.

11. Personensicherheitseinheit für ein Fahrzeug mit einer Insassen- und/oder Verkehrsteilnehmerschutzvorrichtung, die als Verbraucher mit der Energieversorgungseinheit (200) gemäß einem der Ansprüche 1 bis 10 gekoppelt ist.

12. Verfahren (500) zum Betrieb einer Energieversorgungseinheit (200) gemäß einem der vorangegangenen Ansprüche 1 bis 10 zur autarken Versorgung eines Verbrauchers, wobei das Verfahren (500) die folgenden Schritte aufweist:

- Setzen (510) des Überwachungssignals auf einen Aktivzustand, wenn eine zwischen dem Ausgang und einem Referenzpotenzial anliegende Ausgangsspanung geringer als ein vordefinierter Aktivierungsschwellwert ist; und
- Bringen (520) des Überwachungssignals in einen Inaktivzustand, wenn eine zwischen dem Eingang und dem Referenzpotenzial anliegende Eingangsspannung wieder über einen Rücksetzschwellwert gestiegen ist.

13. Computer-Programmprodukt mit Programmcode zur Durchführung des Verfahrens (500) nach Anspruch 12, wenn das Programmprodukt auf einer Energieversorgungseinheit (200) gemäß einem der Ansprüche 1 bis 10 ausgeführt wird.

**Claims**

1. Energy supply unit (200) for autonomously supplying power to a load (140), wherein the energy supply unit (200) comprises the following features:

- an energy storage unit (ER) that is designed to deliver electrical energy to a load (140) if the electrical load (140) is decoupled from an energy supply network (115);
- an energy supply regulator unit (100) having an input (110), which is coupled to the energy storage unit (ER), for taking up electrical energy and an output (130) for outputting electrical energy to the load (140); wherein the energy supply unit is **characterized in that** it further comprises:

- a monitoring unit (230) for outputting a monitoring signal (150, RESET), wherein the monitoring unit (230) is designed to set the monitoring signal (150, RESET) to an active state ("0") if an output voltage (Uout) present between the output (130) and a reference potential (120) is lower than a predefined first activation threshold value (Uout_ru) or greater than a predefined second activation threshold value (Uout_ro), wherein the monitoring unit (230) is also designed to reset the monitoring signal (150, RESET) to an inactive state ("1") if an input voltage (Uin) present between the input (110) and the reference potential (120) again increases or is above a reset threshold value (Uin_min).

2. Energy supply unit (200) according to Claim 1, **characterized in that** the monitoring unit (230) is designed to keep the monitoring signal (150, RESET) in the active state ("0"), irrespective of regulator output voltage monitoring, if the input voltage (Uin) is lower than a third activation threshold value (Uin_min) and/or the output voltage (Uout) is lower than the first activation threshold value (Uout_ru) once or for a particular time window (Tf1), in particular wherein the third activation threshold value (Uin_min) is equal to the reset threshold value (Uin_min).

3. Energy supply unit (200) according to either of the preceding claims, **characterized in that** the monitoring unit (230) is designed to switch the monitoring signal (150, RESET) to the active state ("0") if the input voltage (Uin) is lower than the third activation threshold (Uin_min), in particular if the irrespective of monitoring of the output voltage (Uout) of the energy supply regulator unit (100) by the input voltage (Uin) is lower than the third activation threshold, wherein in particular the third activation threshold value (Uin_min) is chosen such that the output voltage (Uout) of the energy supply regulator unit (100), up to a voltage value that corresponds to the third activation threshold value (Uin_min), does not leave a regulated voltage range of the output voltage even under full current load.

4. Energy supply unit (200) according to one of the preceding claims, **characterized in that** the monitoring unit (230) is designed to switch the monitoring signal (150, RESET) to the inactive state ("1") if the input voltage (Uin) is greater than or equal to a predefined reset threshold value, in particular wherein the reset threshold value is chosen such that the input voltage (Uin) of the energy supply regulator unit (100) does not leave a regulated input voltage range due to the output voltage being reset, which results in a current load reduction of the energy supply regulator unit (100), even when the energy storage unit has a finite internal resistance, in particular wherein the reset threshold value corresponds to a value that is able to be determined by the third activation threshold plus the product of the maximum current (ILonmax) times the internal resistance (Ri) of the energy storage unit (ER) and/or a diode connection to the input (110) of the energy supply regulator unit (100).

5. Energy supply unit (200) according to one of the preceding claims, **characterized in that** the monitoring unit (230) comprises at least one digital circuit (240), in particular a logic circuit, in order to generate the monitoring signal (150, RESET).

6. Energy supply unit (200) according to one of the preceding claims, **characterized in that** the monitoring unit (230) comprises at least one digital circuit (240), in particular a logic circuit, that is designed to be clocked with a continuous digital clock signal in order to determine at least one follow-on time during which a filter and/or the monitoring signal (RESET) is/are kept in the active state.

7. Energy supply unit (200) according to one of the preceding claims, **characterized in that** the monitoring unit (230) comprises one or more resettable flip-flop elements (315), in particular D-type flip-flops, in order to generate the monitoring signal (150, RESET).

8. Energy supply unit (200) according to one of the preceding claims, **characterized in that** the monitoring unit (230) comprises at least one resettable flip-flop element (315) that is resettable depending on the input voltage (Uin).

9. Energy supply unit (200) according to one of the preceding claims, **characterized in that** the monitoring unit (230) comprises at least one resettable flip-flop element (315) that is able to be clocked depending on the output voltage (Uout) and/or the input voltage (Uin).

10. Energy supply unit (200) according to one of the preceding claims, **characterized in that** the monitoring unit (230) is designed to delay the output of the monitoring signal (150, RESET) in the second state ("0") by a predefined period of time (Tf2) if the monitoring signal (150, RESET) changes from a first state ("1") to a second state ("0"), and to not delay the output of the monitoring signal (150, RESET) in the first state ("1") if the monitoring signal (150, RESET) changes from the second state ("0") to the first state ("1").

11. Personal safety unit for a vehicle, having an occupant protection device and/or road user protection device that is/are coupled to the energy supply unit (200) according to one of Claims 1 to 10 as the load.

12. Method (500) for operating an energy supply unit (200) according to one of the preceding Claims 1 to 10 for autonomously supplying power to a load, wherein the method (500) comprises the following steps:

EP 2 951 596 B1

- setting (510) the monitoring signal to an active state if an output voltage present between the output and a reference potential is lower than a predefined activation threshold value; and
- bringing (520) the monitoring signal to an inactive state if an input voltage present between the input and the reference potential has again increased above a reset threshold value.

**13.** Computer program product having program code for carrying out the method (500) according to Claim 12 if the program product is executed on an energy supply unit (200) according to one of Claims 1 to 10.

**Revendications**

**1.** Unité d'alimentation en énergie (200) pour l'alimentation autonome d'un consommateur (140), l'unité d'alimentation en énergie (200) présentant les particularités suivantes :

- un accumulateur d'énergie (ER) qui est réalisé pour fournir de l'énergie électrique à un consommateur (140) lorsque le consommateur électrique (140) est découplé d'un réseau d'alimentation en énergie (115) ;
- une unité de régulation d'alimentation en énergie (100) pourvue d'une entrée (110) couplée à l'accumulateur d'énergie (ER) pour recevoir de l'énergie électrique, et pourvue d'une sortie (130) pour délivrer de l'énergie électrique au consommateur (140) ; l'unité d'alimentation en énergie étant **caractérisée en ce qu'**elle présente en outre :

- une unité de surveillance (230) pour émettre un signal de surveillance (150, RESET), l'unité de surveillance (230) étant réalisée pour régler le signal de surveillance (150, RESET) sur un état actif (« 0 ») lorsqu'une tension de sortie (Uout) appliquée entre la sortie (130) et un potentiel de référence (120) est inférieure à une première valeur seuil d'activation (Uout_ru) prédéfinie ou supérieure à une deuxième valeur seuil d'activation (Uout_ro) prédéfinie, dans laquelle l'unité de surveillance (230) est en outre réalisée pour réinitialiser le signal de surveillance (150, RESET) sur un état inactif (« 1 ») lorsqu'une tension d'entrée (Uin) appliquée entre l'entrée (110) et le potentiel de référence (120) remonte ou se situe à nouveau au-dessus d'une valeur seuil de réinitialisation (Uin_min).

**2.** Unité d'alimentation en énergie (200) selon la revendication 1, **caractérisée en ce que** l'unité de surveillance (230) est réalisée pour maintenir le signal de surveillance (150, RESET) à l'état actif (« 0 ») indépendamment d'une surveillance de tension de sortie de régulateur, quand une seule fois ou pendant une fenêtre de temps (Tf1) déterminée, la tension d'entrée (Uin) est inférieure à une troisième valeur seuil d'activation (Uin_min) et/ou la tension de sortie (Uout) est inférieure à la première valeur seuil d'activation (Uout_ru), en particulier dans laquelle la troisième valeur seuil d'activation (Uin_min) est égale à la valeur seuil de réinitialisation (Uin_min).

**3.** Unité d'alimentation en énergie (200) selon l'une quelconque des revendications précédentes, **caractérisée en ce que** l'unité de surveillance (230) est réalisée de façon à commuter le signal de surveillance (150, RESET) à l'état actif (« 0 ») lorsque la tension d'entrée (Uin) est inférieure au troisième seuil d'activation (Uin_min), en particulier lorsque la indépendamment d'une surveillance de la tension de sortie (Uout) de l'unité de régulation d'alimentation en énergie (100) par la tension d'entrée (Uin) est inférieure au troisième seuil d'activation, dans laquelle en particulier la troisième valeur seuil d'activation (Uin_min) est choisie de telle sorte que la tension de sortie (Uout) de l'unité de régulation d'alimentation en énergie (100), jusqu'à une valeur de tension qui correspond à la troisième valeur seuil d'activation (Uin_min), ne quitte pas une plage de tension régulée de la tension de sortie même sous pleine charge de courant.

**4.** Unité d'alimentation en énergie (200) selon l'une quelconque des revendications précédentes, **caractérisée en ce que** l'unité de surveillance (230) est réalisée de façon à commuter le signal de surveillance (150, RESET) à l'état inactif (« 1 ») si la tension d'entrée (Uin) est supérieure ou égale à une valeur seuil de réinitialisation prédéfinie, en particulier dans laquelle la valeur seuil de réinitialisation est sélectionnée de telle sorte que la tension d'entrée (Uin) de l'unité de régulation d'alimentation en énergie (100) ne quitte pas une plage de tension d'entrée régulée même en présence d'une résistance interne finie de l'accumulateur d'énergie par une réinitialisation de la tension de sortie entraînant une réduction de charge de courant de l'unité de régulation d'alimentation en énergie (100), en particulier dans laquelle la valeur seuil de réinitialisation correspond à une valeur qui peut être déterminée par le troisième seuil d'activation plus le produit du courant maximal (ILonmax) et de la résistance interne (Ri) de l'accumulateur d'énergie (ER) et/ou d'une connexion en diode avec l'entrée (110) de l'unité de régulation d'alimentation en énergie (100).

15

5. Unité d'alimentation en énergie (200) selon l'une quelconque des revendications précédentes, **caractérisée en ce que** l'unité de surveillance (230) présente au moins un circuit numérique (240), en particulier un circuit logique, pour générer le signal de surveillance (150, RESET) .

6. Unité d'alimentation en énergie (200) selon l'une quelconque des revendications précédentes, **caractérisée en ce que** l'unité de surveillance (230) présente au moins un circuit numérique (240), en particulier un circuit logique qui est réalisé pour être cadencé par un signal d'horloge numérique continu afin de déterminer au moins un temps de poursuite pendant lequel un filtre et/ou le signal de surveillance (RESET) sont maintenus à l'état actif.

7. Unité d'alimentation en énergie (200) selon l'une quelconque des revendications précédentes, **caractérisée en ce que** l'unité de surveillance (230) présente un ou plusieurs éléments de bascule bistable (315) réinitialisables, en particulier de type bascule D, pour générer le signal de surveillance (150, RESET).

8. Unité d'alimentation en énergie (200) selon l'une quelconque des revendications précédentes, **caractérisée en ce que** l'unité de surveillance (230) présente au moins un élément de bascule bistable (315) réinitialisable qui peut être réinitalisé en fonction de la tension d'entrée (Uin).

9. Unité d'alimentation en énergie (200) selon l'une quelconque des revendications précédentes, **caractérisée en ce que** l'unité de surveillance (230) présente au moins un élément de bascule bistable (315) réinitialisable qui peut être cadencé en fonction de la tension de sortie (Uout) et/ou de la tension d'entrée (Uin).

10. Unité d'alimentation en énergie (200) selon l'une quelconque des revendications précédentes, **caractérisée en ce que** l'unité de surveillance (230) est réalisée, en cas de changement du signal de surveillance (150, RESET) d'un premier état (« 1 ») à un deuxième état (« 0 »), pour retarder la sortie du signal de surveillance (150, RESET) dans le deuxième état (« 0 ») d'une durée prédéfinie (Tf2), et en cas de changement du signal de surveillance (150, RESET) du deuxième état (« 0 ») au premier état (« 1 »), pour ne pas retarder la sortie du signal de surveillance (150, RESET) dans le premier état (« 1 »).

11. Unité de sécurité personnelle pour un véhicule comprenant un dispositif de protection des passagers et/ou des usagers de la route, qui est couplé en tant que consommateur à l'unité d'alimentation en énergie (200) selon l'une quelconque des revendications 1 à 10.

12. Procédé (500) permettant de faire fonctionner une unité d'alimentation en énergie (200) selon l'une quelconque des revendications précédentes 1 à 10 pour l'alimentation autonome d'un consommateur, le procédé (500) présentant les étapes suivantes consistant à :

    - régler (510) le signal de surveillance sur un état actif lorsqu'une tension de sortie appliquée entre la sortie et un potentiel de référence est inférieure à une valeur seuil d'activation prédéfinie ; et
    - amener (520) le signal de surveillance dans un état inactif lorsqu'une tension d'entrée appliquée entre l'entrée et le potentiel de référence est remontée au-dessus d'une valeur seuil de réinitialisation.

13. Produit de programme informatique, comprenant du code programme pour exécuter le procédé (500) selon la revendication 12 lorsque le produit de programme est exécuté sur une unité d'alimentation en énergie (200) selon l'une quelconque des revendications 1 à 10.

Fig. 1A

Fig. 1B

EP 2 951 596 B1

Fig. 2A

EP 2 951 596 B1

Fig. 2B

Fig. 2C

EP 2 951 596 B1

EP 2 951 596 B1

Fig. 3A

| 355 | 360 | | | 370 | |
|---|---|---|---|---|---|
| | $\overline{MR}$ | CP | D | Q | $\overline{Q}$ |
| RESET | 0 | X | X | 0 | 1 |
| „1" | 1 | 0→1 | 1 | 1 | 0 |
| „0" | 1 | 0→1 | 0 | 0 | 1 |

Fig. 3B

Fig. 3C

Fig. 4A

EP 2 951 596 B1

| 455 | 460 | | | 470 | |
|---|---|---|---|---|---|
| | $\overline{MR}$ | CP | D | Q | $\overline{Q}$ |
| clear | 0 | X | X | 0 | 1 |
| „1" | 1 | 0→1 | 1 | 1 | 0 |
| „0" | 1 | 0→1 | 0 | 0 | 1 |

Fig. 4B

Fig. 4C

500

510

520

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5142215 A